# EUROPÄISCHE PATENTANMELDUNG

(11) **EP 2 234 146 A2**
(43) Veröffentlichungstag der Anmeldung: **29.09.2010**
(21) Anmeldenummer: 10000959.6
(22) Anmeldetag: 30.01.2010
(51) Int. Cl.: H01L 21/334, H01L 21/822, H01L 27/07, H01L 27/10, H01L 29/94

(54) **Verfahren zum Herstellen einer Mehrzahl von integrierten Halbleiterbauelementen**

(30) Priorität: 26.03.2009 DE 102009001919
(71) Anmelder: SEMIKRON Elektronik GmbH & Co. KG, 90431 Nürnberg (DE)
(72) Erfinder: Berberich, Sven, Dr., 91080 Spardorf (DE)

(57) **Zusammenfassung**

Bei einem Verfahren zum Herstellen einer Mehrzahl von integrierten Halbleiterbauelementen (8) auf einem Träger (2) wird eine aktive Grundstruktur (4) in den Träger (2) zumindest über einen Teil der Grenzen (10) von zu erstellenden Halbleiterbauelementen (8) hinweg durchgängig eingebracht, werden die Bereiche der Halbleiterbauelemente (8) auf dem Träger (2) festgelegt, wird im Bereich jedes Halbleiterbauelements (8) mit Hilfe einer Maske (12) eine Deckschicht (14) auf den Träger (2) aufgebracht, und wird der Träger (2) unter Bildung der Halbleiterbauelemente (8) an deren Grenzen (10) durchtrennt.

## Beschreibung

Die Erfindung betrifft ein Verfahren zum Herstellen einer Mehrzahl von integrierten Halbleiterbauelementen. In der Halbleitertechnik werden integrierte Halbleiterbauelemente in der Regel nicht einzeln, sondern im Verbund eines Trägers, z.B. eines Siliziumwafers hergestellt. Hierbei wird also auf einem einzigen Träger eine Mehrzahl von Bauelementen gleichzeitig unter Durchlaufen verschiedener Prozessschritte hergestellt.

Für verschiedene elektronische Schaltungen der Leistungselektronik sind sogenannte Beschaltungsnetzwerke notwendig, welche in der betreffenden Schaltung parasitäre Energien vernichten bzw. dieser entziehen und später rückspeisen. Derartige Schaltungen werden Snubber genannt und bestehen in der Regel aus einfachen Verschaltungen von Widerständen, Kapazitäten und Induktivitäten. In einem derartigen Beschaltungsbauelement, z.B. einem RC-Glied, wird die parasitäre Energie z.B. in Form von Wärme vernichtet.

Aus der DE 10 2006 017 487 A1 ist es bekannt, Snubber in integrierter Bauweise als integriertes Halbleiterbauelement herzustellen. Gemäß der Veröffentlichung "Berberich, S.E.; Bauer, A.J.; Ryssel, H., High Voltage 3D-Capacitor, 12th European Conference on Power Electronics and Applications 2007. Proceedings EPE '07, 02-05. September 2007, Aalborg, Denmark" ist es bekannt, integrierte Snubberbauelemente als 3D-Snubber in einem Herstellungsprozess zu fertigen, welcher ein Derivat einer standardisierten CMOS-Siliziumtechnolgie darstellt. Die elektrischen Eigenschaften der Bauelemente werden unter anderem durch die Stärke der Dotierung der Halbleitermaterialien und die Fläche bzw. Größe der Bauelemente gesteuert.

Mit anderen Worten werden Photolithographieschritte zur Skalierung der Bauelementgrundfläche bzw. Festlegung der Chipfläche und zur Strukturierung der Metallisierung verwendet.

Die beschriebene Technologie hat einen großen prozesstechnischen Aufwand zur Folge. Ferner ist der Aufwand zur Skalierung der Bauelemente, d.h. hinsichtlich ihrer Chipgröße, Kapazitätswert und Widerstandswert der Snubberbauelemente hoch. Für eine Änderung des Widerstandes wird hierbei z.B. die Fläche des jeweiligen Chips oder die Dotierung des Wafers geändert. Für eine Änderung der Kapazität eines Bauelements wird die Bauelementfläche verändert, z.B. benötigt man zur Herstellung eines 15nF-Kondensators mit einer Spannungsfestigkeit über 200V eine Fläche von ca. 15µm², für einen 20nF-Kondensator ca. 20µm².

Aufgabe der Erfindung ist es, ein Verfahren anzugeben, bei dem während der Herstellung von 3D-Snubberbauelementen diese in einfacherer Weise skalierbar sind.

Die Erfindung beruht auf der Erkenntnis, dass bei dem bekannten standardisierten CMOS-Prozess die Bauelementgröße bzw. die Fläche des Bauelementes in jedem einzelnen Prozessschritt berücksichtigt werden muss. Z.B. muss bei der Änderung der Bauteilfläche eines integrierten Kondensators, um dessen Kapazitätswert zu verändern, dies in sämtlichen Maskenschritten des gesamten Prozesses berücksichtigt werden. Weiter wird die Erkenntnis berücksichtigt, dass integrierte Snubber aus einer aktiven Grundstruktur bestehen, die von einer strukturierten Deckschicht, z.B. der oberen Metallisierung bedeckt ist. Die Grundstruktur enthält nicht die Deckschicht. Die Grundstruktur an sich ist für Bauteile verschiedener Dimensionen gleich. Die Grundstruktur sind z.B. in den Wafer eingebrachte Löcher, die mit einem Dielektrikum ausgekleidet sind, um durch die Deckschicht schließlich einen Kondensator zu bilden.

Die Erfindung geht daher von der Idee aus, die Bauelemente auf dem Träger derart herzustellen, dass die aktive Grundstruktur zunächst ohne Berücksichtigung der späteren eigentlichen Bauteilgrenzen durchgängig, lückenlos, unterbrechungsfrei bzw. flächig, also ohne Grenzen bzw. reservierte Schnittbereiche über dem gesamten Träger hergestellt wird. Die Grundstruktur ist mit anderen Worten im Bereich der später entstehenden Bauelemente nicht nach einzelnen Chips strukturiert, und somit nicht auf die gewünschten Bauteilabmessungen limitiert. Zunächst bleiben also spätere Bauteilgrenzen bzw. Schnittbereiche, an denen die Bauteile später vereinzelt werden, unberücksichtigt.

Das Bauelement wird schlussendlich erst durch die Deckschicht auf einen bestimmten Bereich des Trägers begrenzt. Die eigentliche Abgrenzung der Bauteile entsteht also erst in einem nächsten Schritt durch gezielte Aufbringung der Metallisierungen in und nur in den Bereichen, welche später das jeweilige einzelne Bauteil bilden sollen. Die Metallisierung, d.h. die obere Elektrode bzw. Sägeseite des Snubberbauelements wird dabei mit einem Maskenverfahren, z.B. einer sogenannten Schattenwurfmaske strukturiert.

Die Aufgabe wird daher gelöst durch ein Verfahren gemäß Patentanspruch 1. Das Verfahren dient zum Herstellen einer Mehrzahl von integrierten Halbleiterbauelementen auf einem Träger und weist folgende Schritte auf: Auf dem Träger wird die aktive Grundstruktur wie oben erläutert eingebracht, d.h. zumindest über einen Teil der Grenzen von zu erstellenden Bauelementen hinweg durchgängig. Die Bereiche der Halbleiterbauelemente auf dem Träger werden erst dann festgelegt. Mit anderen Worten wird Lage, Größe und Form jedes Halbleiterbauelementes bzw. dessen Grenzen auf dem Träger festgelegt.

In jedem Bereich, welcher später ein Halbleiterbauelement ausmachen soll, wird dann mit Hilfe einer Maske bzw. eines Maskenverfahrens eine Deckschicht auf den Träger bzw. auf die aktive Grundstruktur aufgebracht. Abschließend wird der Träger unter Bildung der Halbleiterbauelemente an den Grenzen durchtrennt.

Das Verfahren bietet den wesentlichen Vorteil, dass lediglich anhand der Deckschicht bzw. des Maskenverfahrens letztendlich die Bauelementgröße, Gestalt oder Position auf dem Träger festgelegt wird, und damit die herzustellenden integrierten Halbleiterbauelemente anhand dieses einen Schrittes besonders einfach festgelegt werden können. Anhand der Struktur der Maske im Maskenverfahren kann somit die Bauelementgröße und damit z.B. Kapazitätswert, Widerstandswert oder Chipfläche im Verfahren frei, d.h. besonders einfach und kostengünstig skaliert werden. Dies senkt im erheblichen Umfang die Aufwendungen bezüglich Entwicklung, Prozesstechnik und Kosten zur Herstellung von derartigen Halbleiterbauelementen.

In einer bevorzugten Ausführungsform des Verfahrens werden als Grundstruktur in den Träger flächig nebeneinander angeordnete, gleiche Strukturelemente eingebracht. Derartige Strukturelemente sind in der Regel um Größenordnungen kleiner als die Fläche des integrierten Halbleiterbauelementes. Mit anderen Worten besteht jedes integrierte Halbleiterbauelement aus einer sehr großen Anzahl solcher gleicher Strukturelemente. Die Dimensionierung des Bauelementes erfolgt mit anderen Worten durch die Anzahl der Strukturelemente, welche das Bauelement später aufweist, also durch die vom Halbleiterbauelement bedeckte Fläche des Trägers.

Besonders für eine derartige Grundstruktur ist es von Vorteil, dass die Strukturelemente flächig ohne Berücksichtigung der Bauteilgrenzen über den gesamten Träger eingebracht werden können, was auch diesen Prozessschritt deutlich vereinfacht.

In einer bevorzugten Ausgestaltung des oben genannten Verfahrens werden als Strukturelemente Loch- oder Grabenstrukturen in den Träger eingebracht. Snubberbauelemente mit derartigen Lochstrükturen sind z.B. aus der bereits genannten DE 10 2006 017 487 A1 bekannt. Diese eignen sich besonders gut zur Herstellung von integrierten Kondensatoren.

Die Grundstruktur erstreckt sich gemäß dem Verfahren zumindest über einen Teil der Grenzen der Bauteile hinweg, d.h. auch über Bereiche des Trägers, die später bei der Vereinzelung der Bauteile durchtrennt werden müssen. In einer Ausgestaltung des Verfahrens weist die Grundstruktur eine Hilfsschicht, z.B. eine bestimmte Schicht, auf, welche z.B. bei der späteren Vereinzelung der Bauelemente Probleme bereitet. Dies sind z.B. Teile der Grundstruktur, welche z.B. beim Trennen des Trägers Probleme verursachen würden, sich z.B. beim Sägen verschmieren oder unerwünschte Kurzschlüsse zwischen einzelnen Schichten herstellen würden. In dieser Ausführungsform des Verfahrens wird vor Durchtrennung des Trägers an den Grenzen der Bauelemente der entsprechende Teil der Hilfsschicht später wieder entfernt.

In einer Ausgestaltung des genannten Verfahrens ist der angesprochene Teil der Grundstruktur eine oberste Hilfsschicht, die im anschließenden Schritt dann von der Deckschicht bedeckt wird.

In einer weiteren Ausgestaltung des Verfahrens wird als Hilfsschicht Polysilizium verwendet. Außerdem kann zur Entfernung dieser Hilfsschicht TMAH (Tetramethyl-Ammoniumhydroxidlösung) verwendet werden. TMAH kann z.B. besonders einfach eine hochdotierte Polysiliziumschicht als Hilfsschicht entfernen. Polysilizium wird hierbei ebenfalls global, also ohne Berücksichtigung der Grenzen, auf dem Träger abgeschieden. TMAH arbeitet dabei selektiv zum Metall der Deckschicht in den exponierten, also nicht von Metall bedeckten Bereichen. Für die Entfernung der Hilfsschicht ist dann kein spezieller Schritt mehr notwendig, da die bereits aufgebrachte Metallisierung als Maske für TMAH wirkt.

In einer weiteren bevorzugten Ausführungsform des Verfahrens wird die Deckschicht mit Hilfe einer Schattenwurfmaske erzeugt. Die Verwendung einer Schattenwurfmaske in einem Prozessschritt ist besonders kostengünstig und einfach realisierbar.

In einer weiteren Ausführungsform des Verfahrens wird als Deckschicht Metall aufgebracht.

In einer anderen Ausgestaltung des Verfahrens wird als Träger eine Siliziumscheibe verwendet.

In einer weiteren Ausgestaltung des Verfahrens wird als Halbleiterbauelement ein Beschaltungsbauelement auf Halbleiterbasis erzeugt.

In einer Ausgestaltung dieses Verfahrens wird als Halbleiterbauelement ein 3D-Snubber erzeugt.

Für eine weitere Beschreibung der Erfindung wird auf die Ausführungsbeispiele der Zeichnungen verwiesen. Es zeigen, jeweils in einer schematischen Prinzipskizze:
- Fig. 1: einen Träger mit mehreren Hableiterbauelementen,
- Fig. 2: einen Querschnitt durch den Träger bzw. ein Hableiter bauelement,
- Fig. 3: einen Querschnitt gemäß Fig. 2 für eine alternative Ausführungsform eines Bauelementes.

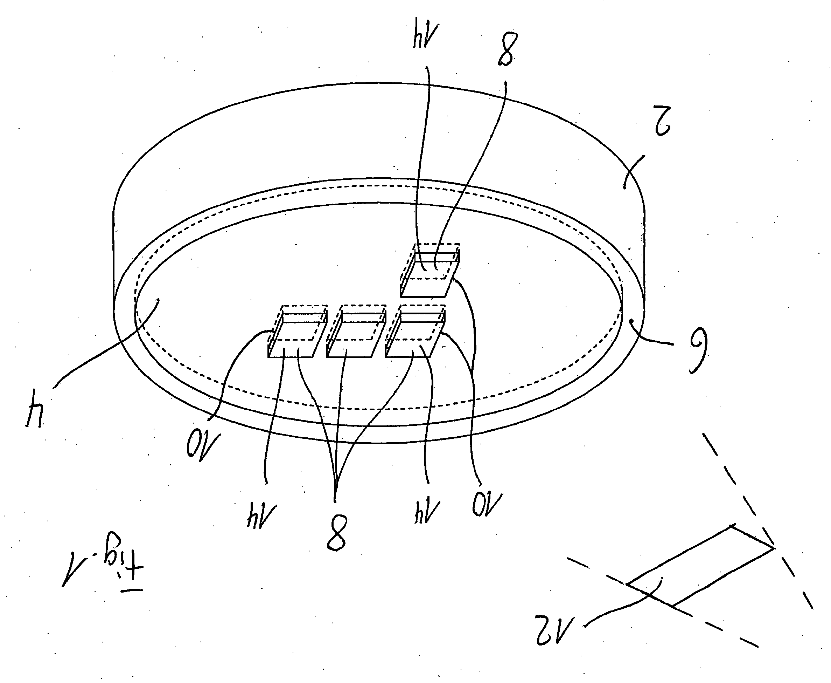

Fig. 1 zeigt als Träger 2 einen Siliziumwafer. Auf dem Träger 2 soll später eine Vielzahl von Halbleiterbauelementen 8 entstehen (nur drei dargestellt), deren genaue Ortslage auf dem Träger 2 jedoch für den im folgenden beschriebenen ersten Verfahrensschritt noch keinerlei Bedeutung hat. Die Lage und Position bzw. die Grenzen 10 der entstehenden Halbleiterbauelemente 8 müssen somit für den ersten Verfahrensschritt nicht bekannt sein, obwohl dies in der Praxis in der Regel zutrifft.

In den Träger 2 wird nun im ersten Verfahrensschritt eine Grundstruktur 4 eingebracht, ohne auf die spätere Lage bzw. insbesondere die Grenzen 10 der erst später entstehenden Halbleiterbauelemente 8 Rücksicht zu nehmen. Die Grundstruktur 4 wird also in die Oberfläche 6 des Trägers unterbrechungsfrei, durchgängig, lückenlos, ohne Berücksichtigung-der späteren Grenzen 10 eingebracht. Die Grundstruktur 4 ist damit insbesondere bezüglich der späteren Bereiche der Halbleiterbauelemente 8 unstrukturiert, also nicht auf deren gewünschte Abmessungen limitiert.

In einem zweiten Schritt werden nun auf der Oberfläche 6 bzw. dem Träger 2 Halbleiterbauelemente 8 bzw. deren Grenzen 10 geplant, definiert bzw. festgelegt. Dementsprechend wird eine Maske 12 angefertigt: Im Bereich jedes Halbleiterbauelementes 8 wird dann mit Hilfe der Maske 12, im Beispiel einer Schattenwurfmaske, eine Deckschicht 14, im Beispiel Metall, auf die Grundstruktur 4 aufgebracht. Dies erfolgt im Gegensatz zur Aufbringung der Grundstruktur 4 unter Berücksichtigung der Grenzen 10, d.h. die Deckschicht 14 wird nur im Bereich der Halbleiterbauelemente 8 selektiv aufgebracht. Im Bereich der Grenzen bleibt der Träger frei von der Deckschicht 14.

In einem abschließenden Schritt wird nun der Träger 2 bzw. die Halbleiterbauelemente 8 vereinzelt, indem im Bereich der Grenzen 10 der Träger 2 auf seiner gesamten Dicke, d.h. zusammen mit der auch dort vorhandenen Grundstruktur 4 durchtrennt wird.

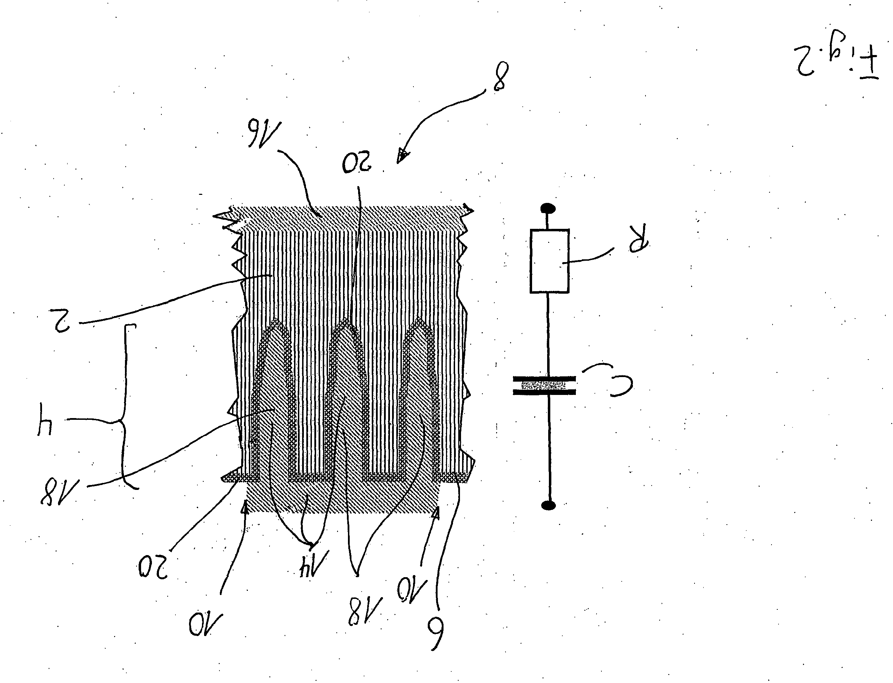

Fig. 2 zeigt einen Querschnitt durch den Träger 2 bzw. ein Halbleiterbauelement 8. In Fig. 2 ist nochmals der Träger 2 in Form des Siliziumsubstrates mit einer Metallisierung 16 als Bodenelektrode zu sehen. Die Grundstruktur 4 besteht in Fig. 2 aus senkrecht von der Oberfläche 6 her in den Träger 2 eingeätzten Strukturelementen 18 in Form von anisotropen Löchern bzw. Graben- oder Lochstrukturen und einer dielektrischen Schicht 20, welche sowohl die Oberfläche 6 als auch die Löcher bzw. den gesamten Träger 2 bedeckt. Die Strukturelemente 18 sind über den gesamten Träger 2 verteilt nebeneinander flächig angeordnet. Auch in Fig. 2 ist zu erkennen, dass sich die gezeigte Grundstruktur 4 unterbrechungsfrei über den gesamten Träger 2 erstreckt, insbesondere nicht die Grenzen 10 des in Fig. 2 dargestellten Halbleiterbauelementes 8 berücksichtigt. In Fig. 2 ist auch die oberste Deckschicht 14 als Metallisierung in Form einer oberen Elektrode zu sehen, welche jedoch auf das Halbleiterbauelement 8 begrenzt abgeschieden wurde. Im Bereich der Grenzen 10 befindet sich daher auf dem Träger 2 keine Deckschicht 14.

Das in Fig. 2 dargestellte Halbleiterbauelement 8 ist ein sogenannter 3D-Snubber, welcher zwischen der Metallisierung 16 und der Deckschicht 14 das in Fig. 2 dargestellte Ersatzschaltbild eines Widerstandes R und eines Kondensators C aufweist. Sowohl der Widerstandswert R als auch der Kapazitätswert C sind hierbei von der Grundfläche bestimmt, welche das Halbleiterbauelement 8 auf dem Träger 4 einnimmt. Mit anderen Worten würden sich die beiden Parameter R und C des Snubberbauelementes ändern, wenn an Stelle der in Fig. 2 dargestellten drei mal drei (quadratisch, im Schnitt nur drei sichtbar) Strukturelemente 18 noch jeweils die benachbarten Strukturelemente 18 (vier mal vier) von der Deckschicht 14 bedeckt würden und somit ein Bauteil aus sechzehn Strukturelementen 18 entstehen würde.

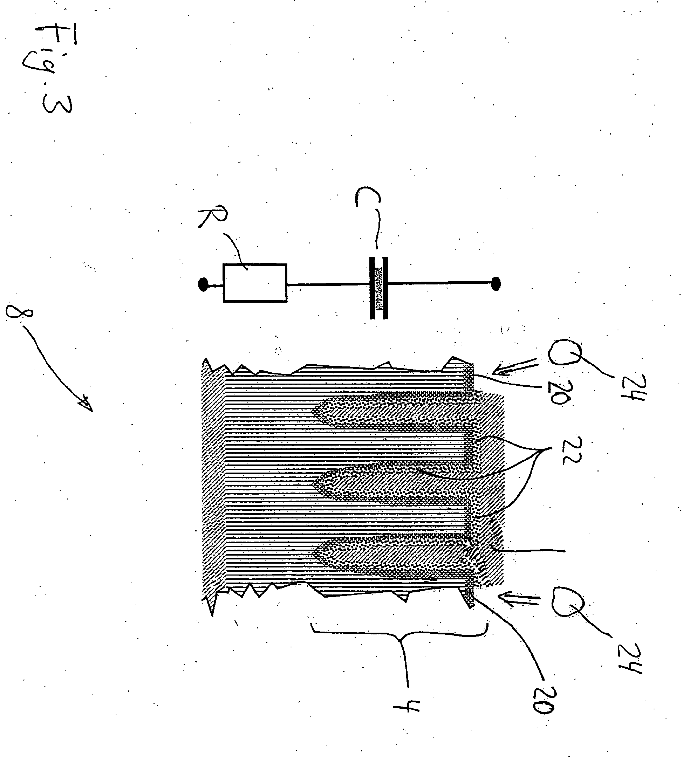

Fig. 3 zeigt eine alternative Ausführungsform eines Halbleiterbauelements 8, bei dem zur Grundstruktur 4 noch eine auf die dielektrische Schicht 20 aufgebrachte weitere Schicht 22 gehört. Diese wurde in Form einer dotierten Polysiliziumschicht als zusätzliche obere Elektrode flächendeckend auf dem Träger 2 abgeschieden. Da die Schicht 22 jedoch nach dem späteren Schneidendes Trägers 2 im Bereich der Grenzen 10 die Isolationsstrecke verkürzt und somit Überschläge im Halbleiterbauelement 8 erzeugen würde, wird nach Aufbringung der Metallisierung 16 die Schicht 22 als Teil der Grundstruktur im Bereich der Grenzen 10 durch Einwirkung von TMAH 24 bis zum Freiliegen der Schicht 20 entfernt.

## Patentansprüche

1. Verfahren zum Herstellen einer Mehrzahl von integrierten Halbleiterbauelementen (8) auf einem Träger (2), bei dem:
- eine aktive Grundstruktur (4) in den Träger (2) zumindest über einen Teil der Grenzen (10) von zu erstellenden Halbleiterbauelementen (8) hinweg durchgängig eingebracht wird,
- die Bereiche der Halbleiterbauelemente (8) auf dem Träger (2) festgelegt werden,
- im Bereich jedes Halbleiterbauelements (8) mit Hilfe einer Maske (12) eine strukturierte Deckschicht (14) auf den Träger (2) aufgebracht wird,
- der Träger (2) unter Bildung der Halbleiterbauelemente (8) an deren Grenzen (10) durchtrennt wird.

2. Verfahren nach Anspruch 1, bei dem als Grundstruktur (4) flächig nebeneinander angeordnete, gleiche Strukturelemente (18,20,22) in den Träger (2) eingebracht werden.

3. Verfahren nach Anspruch 2, bei dem als Strukturelemente (18,20,22) Loch- oder Grabenstrukturen in den Träger (2) eingebracht werden.

4. Verfahren nach einem der vorhergehenden Ansprüche, bei dem vor Durchtrennen des Trägers (2) zumindest ein Teil der Grundstruktur (4) im Bereich der Grenzen (10) entfernt wird.

5. Verfahren nach Anspruch 4, bei dem die Grundstruktur (4) eine oberste Hilfsschicht (22) aufweist, bei dem als Teil der Grundstruktur (4) die Hilfsschicht (22) im Bereich der Grenzen (10) entfernt wird.

6. Verfahren nach Anspruch 5, bei dem als Hilfsschicht (22) Polysilizium verwendet wird.

7. Verfahren nach Anspruch 5 oder 6, bei dem die Hilfsschicht (22) mit Hilfe von TMAH (24) entfernt wird.

8. Verfahren nach einem der vorhergehenden Ansprüche, bei dem die Deckschicht (14) mit Hilfe einer Schattenwurfmaske als Maske (12) erzeugt wird.

9. Verfahren nach einem der vorhergehenden Ansprüche, bei dem als Deckschicht (14) eine Metallisierungsschicht aufgebracht wird.

10. Verfahren nach einem der vorhergehenden Ansprüche, bei dem als Träger (2) eine Siliziumscheibe verwendet wird.

11. Verfahren nach einem der vorhergehenden Ansprüche, bei dem als Halbleiterbauelemente (8) Beschaltungsbauelemente auf Halbleiterbasis erzeugt werden.

12. Verfahren nach Anspruch 11, bei dem als Halbleiterbauelemente (8) 3D-Snubber erzeugt werden.
